# EUROPEAN PATENT APPLICATION

(11) **EP 1 681 367 A1**
(43) Date of publication of application: **19.07.2006**
(21) Application number: 04734739.8
(22) Date of filing: 25.05.2004
(51) Int. Cl.: C23C 14/12, F21S 8/10, F21V 7/22

(54) **FILM-FORMING APPARATUS AND FILM-FORMING METHOD**

(30) Priority: 26.05.2003 JP 2003147227
(71) Applicant: Shinmaywa Industries, Ltd., Takarazuka-shi, Hyogo 665-8550 (JP)
(72) Inventor: NOSE, Koichi Shinmaywa Ind, Ltd., Hyogo 665-8550 (JP); SASAGAWA, Koichi Shinmaywa Ind. Ltd., Hyogo 665-8550 (JP); FURUTSUKA, Takeshi Shinmaywa Ind. Ltd,, Hyogo 665-8550 (JP); TAKIGAWA, Shiro Shinmaywa Ind. Ltd., Hyogo 665-8550 (JP); KOIZUMI, Yasuhiro Shinmaywa Ind, Ltd., Hyogo 665-8550 (JP)
(74) Representative: Neath, Susannah Mairi
(86) International application number: PCT/JP2004/007438
(87) International publication number: WO 2004/104262

(57) **Abstract**

The present invention provides film formation systems and film formation methods. A high frequency (HF) electric power supply (11) applies a high frequency voltage to a cathode (5) which is provided, at its rear surface, with a permanent magnet (10), thereby to generate a reactive-mode plasma, and film formation by plasma polymerization is performed by the use of the generated reactive-mode plasma. The pressure of a plasma source gas in a vacuum chamber (1) is regulated, thereby to generate not a reactive-mode plasma but a metallic-mode plasma. The cathode (5) as a target is subjected to sputtering by the generated metallic-mode plasma, and film formation by magnetron sputtering is carried out.

## Description

### TECHNICAL FIELD

This invention relates to a system and method for film formation by means of a plasma. More specifically, the present invention relates to a system and method improved in the rate of film formation.

### BACKGROUND ART

Reflectors of front and rear lamps or the like for automobiles, motorbikes or the like, are manufactured by laminating paint application or undercoat film of hexamethyldisiloxane or the like, a reflection film of metallic material such as A1 or the like, and a topcoat film formed of hexamethyldisiloxane or the like in that order on a substrate of plastic or the like.

Such type of reflector is manufactured by the following steps. In the first place, an undercoat film is formed by priming. Alternatively, an undercoat film is formed on a substrate by plasma polymerization via a film formation by plasma polymerization system. Thereafter, magnetron sputtering is carried out via a sputter film formation system, and a reflection film is formed on the undercoat film. Then, a film formation by plasma polymerization system is used again to form, by means of plasma polymerization, a topcoat film on the reflection film.

The rate of polymerization reaction is low when forming an undercoat film and a topcoat film by plasma polymerization as described above. It therefore takes a long time to form films of the desired thickness. This causes prolonged production tact time for the manufacture of reflectors.

In addition, when manufacturing a reflector, plasma polymerization and magnetron sputter film forming processes are conducted by different systems, as pointed out above. This results in the requirement that the substrate be transferred between these different systems. Consequently, the production tact time is further increased.

The present invention was made with a view to resolve the above-described problems. Accordingly, an object of the present invention is to provide a film formation system and a film formation method capable of accomplishing improvement in the production tact time.

### DISCLOSURE OF INVENTION

In order to attain the above object, the present invention provides a film formation system and film formation method for generating a plasma within a vacuum chamber and for forming a film on a surface of a substrate by plasma polymerization using the generated plasma, the film formation system comprising: a high frequency electric power supply which generates a high frequency voltage for the plasma generation; an exhaust device which evacuates the vacuum chamber; a plasma source gas supply device which supplies a plasma source gas for the plasma generation to the vacuum chamber; a control unit which regulates the pressure of the plasma source gas in the vacuum chamber so that the plasma in a reactive-mode is generated; a material supply device which supplies the vacuum chamber with material for the plasma polymerization; a cathode and an anode which are connected to the high frequency electric power supply and the cathode and the anode generate an electric discharge for the plasma generation; and a magnetic field generation device which generates a magnetic field around the cathode.

As a result of the above configuration, during formation of the film, a magnetic field is being generated around the cathode. Because of this, electrons of the plasma are trapped by the magnetic field. Concurrently with this, ions gather together. As a result, the plasma density increases, thereby improving the rate of film formation by plasma polymerization. Particularly in this case, it is possible to accomplish high film formation rates even when the level of applied voltage is low. Therefore, it becomes possible to realize a high production tact time.

It may be arranged such that the control unit regulates the flow rate of the plasma source gas which is supplied to the vacuum chamber from the plasma source gas supply device, thereby to regulate the pressure of the plasma source gas. Besides, it may be arranged such that the control unit controls the exhaust device to regulate the degree of vacuum in the vacuum chamber, thereby to regulate the relative pressure of the plasma source gas.

As a result of the above configurations, adjustment of the plasma source gas pressure is facilitated.

It may be arranged such that the film formation system further comprises a target for film formation by magnetron sputtering, the target is disposed in the vacuum chamber; and at the time of the film formation by magnetron sputtering, the control unit regulates the pressure of the plasma source gas in the vacuum chamber so that a metallic-mode plasma is generated.

As a result of the above configuration, in the same film formation system it becomes possible to perform, in addition to film formation by plasma polymerization, film formation by magnetron sputtering and, besides, it becomes possible to realize a high film formation rate even in the film formation by magnetron sputtering. Furthermore, switching between the film formation by plasma polymerization and the film formation by magnetron sputtering can be made easily by adjustment of the plasma source gas pressure in the vacuum chamber. In such a system capable of both film formation by plasma polymerization and film formation by magnetron sputtering, it becomes possible to reduce system costs as well as to achieve a system size reduction. In addition, particularly when carrying out film formation by plasma polymerization and film formation by magnetron sputtering in succession, it is possible to successively form films by means of different techniques in the same film formation system, thereby eliminating the need for the intersystem transferring of a substrate as required in the case where film formation by plasma polymerization and film formation by magnetron sputtering process are carried out by different systems. Therefore, it becomes possible to accomplish further improvement in the production tact time.

It may be arranged such that a pair of the cathodes is provided, and the pair of cathodes is connected to the high frequency electric power supply.

In the above configuration, the cathodes are provided as a pair of cathodes, and each cathode functions oppositely in polarity to each other at each discharge, and function alternately as a negative and positive electrode. Consequently, it becomes possible to increase the amount of electric power supplyable to the high frequency electric power supply. Therefore, the rate of film formation by plasma polymerization and the rate of film formation by magnetron sputtering are improved to a further extent.

It may be arranged such that the vacuum chamber is composed of an electrically conductive member, the high frequency voltage is impressed between the pair of the cathodes, and a chamber connection circuit is provided which selects either cathode of the pair of cathodes, whichever functions as a positive electrode, according to the polarity change of the high frequency voltage, and the chamber connection circuit electrically connects the selected cathode to the vacuum chamber.

In the above configuration, the positive electrode area increases, thereby preventing the occurrence of yellowing during Al film formation.

It is preferable that the chamber connection circuit is so configured as to be capable of electrically disconnecting the pair of cathodes from the vacuum chamber.

As a result of the above configuration, it becomes possible to electrically connect together the cathodes and the vacuum chamber, only in the metallic-mode which requires prevention against yellowing.

It may be arranged such that a plurality of sets of the cathode pairs are provided. As a result of the above configuration, the rate of film formation is improved to a further extent.

It may be arranged such that the film formation system further comprising a supply roll and a take-up roll, whereby the substrate shaped like a continuous film is continuously supplied to a reaction section of the vacuum chamber in which the cathode is disposed and in which the film formation is carried out.

As a result of the above configuration, it becomes possible to continuously supply the substrate to the reaction section, thereby making it possible to perform continuous film formation. Here, as stated previously, the rate of film formation by plasma polymerization and the rate of film formation by magnetron sputtering are improved in the above-described film formation system. Therefore, it becomes possible to supply the substrate rapidly. In such a system, it is possible to quickly form a film all over the substrate, thereby accomplishing improvement in the production tact time.

It may be arranged such that the reaction section is divided into a first reaction part located upstream relative to a direction in which the substrate is supplied and a second reaction part located downstream relative to the substrate supply direction, and a cathode connected to a first high frequency electric power supply is disposed in the first reaction part, and a cathode connected to a second high frequency electric power supply is disposed in the second reaction part, and the pressure of the plasma source gas in each of the first and second reaction parts is regulated by the control unit independently so that either the reactive-mode plasma or the metallic-mode plasma is generated in the first reaction part or in the second reaction part independently.

As a result of the above configuration, by generating a plasma in a desired mode in each reaction part, selection, of which of the two film formation means (film formation by plasma polymerization and film formation by magnetron sputtering) is carried out, can arbitrarily be made. And, particularly, by the arrangement that a plasma in one mode is generated in the first reaction part and a plasma in the other mode is generated in the second reaction part, it becomes possible to allow the first and second reaction parts to carry out respective film formation processes. For example, in the case where a reactive-mode plasma is generated and film formation by plasma polymerization is carried out in the first reaction part and, on the other hand, a metallic-mode plasma is generated and film formation by magnetron sputtering is carried out in the second reaction part, a second film formed by magnetron sputtering in the second reaction part is formed on a first film formed by plasma polymerization in the first reaction part. Therefore, it becomes possible to form films, of different types by means of different film formation methods, in a single production line, thereby accomplishing improvement in the production tact time.

It may be arranged such that the plasma source gas supply device supplies the plasma source gas to the first reaction part and to the second reaction part independently, and the control unit controls the plasma source gas supply device, thereby to regulate the supply flow rates of the plasma source gas to the first and second reaction parts independently, whereby the pressures of the plasma source gas in the first reaction part and the second reaction part are regulated independently. Furthermore, it may be arranged such that the exhaust device evacuates the first reaction part and the second reaction part independently, and the control unit controls the exhaust device, thereby to regulate the degrees of vacuum of the first and second reaction part independently, whereby the pressures of the plasma source gas in the first and second reaction part are regulated independently.

As a result of the above configurations, it becomes possible to regulate the plasma source gas pressure for each of the first and second reaction parts independently.

These objects as well as other objects, features and advantages of the present invention will become apparent from the following detailed description of the preferred embodiments with reference to the accompanying drawings.

### BRIEF DESCRIPTION OF DRAWINGS

Figure 1 is a diagram schematically illustrating a configuration of a film formation system according to embodiment 1 of the present invention;
Figure 2 is a diagram graphically representing a relationship between the pressure of O₂ gas in a vacuum chamber and the rate of film formation by magnetron sputtering;
Figure 3 is a diagram schematically showing a plasma polymerization process occurring in the film formation system of Figure 1;
Figure 4 is a reaction formula for the plasma polymerization of Figure 3;
Figure 5 is a diagram schematically showing a configuration of a film formation system according to embodiment 3 of the present invention;
Figure 6 is a diagram schematically showing a configuration of a film formation system according to embodiment 4 of the present invention;
Figure 7 is a side cross sectional view schematically showing a configuration of a film formation system according to embodiment 5 of the present invention;
Figure 8 is a side cross sectional view schematically showing a configuration of a film formation system according to a modification example of embodiment 5 of the present invention; and
Figure 9 is a diagram schematically showing a configuration of a film formation system according to embodiment 6 of the present invention.

### BEST MODE FOR CARRYING OUT INVENTION

Hereinafter, embodiments of the present invention will be described with reference to the figures.

### Embodiment 1

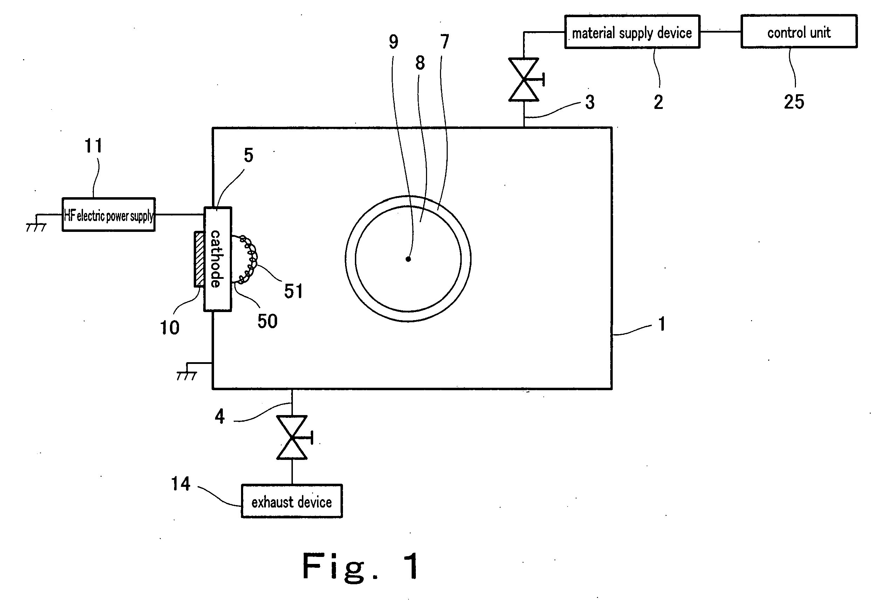

Figure 1 is a diagram schematically illustrating a configuration of a film formation system according to embodiment 1 of the present invention. The film formation system shown in Figure 1 has: a vacuum chamber 1 formed by an electrically conductive member; a material supply device 2 and a supply passageway 3 which supply raw material for film formation and plasma source gas to the vacuum chamber 1; a control unit 25 which controls the material supply device 2; an exhaust device 14 and an exhaust passageway 4 which evacuate the air in the chamber; a cathode 5; a permanent magnet 10 disposed on the rear surface of the cathode 5 (the surface outside the chamber); and a substrate holder 7. Both the supply passageway 3 and the exhaust passageway 4 communicate with the inside of the chamber. A diffusion pump or the like is used as the exhaust device 14.

The cathode 5 of embodiment 1 is made of Cu. A portion of the cathode 5 projects outwardly from the chamber and the rest of the cathode 5 is disposed within the chamber. The substrate holder 7 is disposed within the vacuum chamber 1. The substrate holder 7 is rotatably supported by a supporting structure (not shown) fixedly secured to the bottom surface of the chamber, and is disposed in parallel with the bottom surface of the chamber. The substrate holder 7 may be formed either by an electrically conductive member or by an electrically nonconductive member. In the case where the substrate holder 7 is formed by an electrically conductive member, it becomes possible to prevent abnormal electric discharges during the time of film formation.

The portion of the cathode 5 projecting outwardly from the chamber (hereinafter referred to as the "rear surface side") is connected to a cable. The cathode 5 is connected to a high frequency (HF) electric power supply 11 through the cable. Here, an insulation member (not shown) is placed between the vacuum chamber 1 and the cathode 5, in other words they are electrically isolated from each other. Therefore, in the film formation system of the present embodiment, the vacuum chamber 1 functions as an anode. In addition, the HF electric power supply 11 and the vacuum chamber 1 are both connected to ground. Here, the description will be made in terms of the case where the vacuum chamber 1 functions as an anode. However, another configuration may also be employed in which an anode is provided separately. For example, a flat plate-shaped electrode may be disposed as an anode in the vacuum chamber 1. Alternatively, the substrate holder 7 may be made to function as an anode by making the substrate holder 7 is made to electrically float (to be isolated) from the vacuum chamber 1 and by connecting a cold terminal of the high frequency to the substrate holder 7.

The permanent magnet 10 is mounted on the rear surface of the cathode 5. There is no particular restriction on how the permanent magnet 10 is arranged (more specifically, number of arranged magnets, arrangement position, magnet shape, et cetera). Preferably, the permanent magnet 10 is arranged properly so that lines of magnetic force, capable of concentrating plasma ion effectively, are formed around the cathode 5 during below mentioned film formation by plasma polymerization. For example, a single permanent magnet 10 shaped like a ring or rod may be mounted in the center of the rear surface of the cathode 5. Alternatively, a plurality of permanent magnets 10 may be arranged scatteredly along the outer periphery of the cathode 5.

Next, film formation process by the film formation system of the present embodiment will be described below. The description will be made in terms of the case where, by using the film formation system of the present embodiment, film formation by plasma polymerization is carried out by plasma polymerization of hexamethyldisiloxane (hereinafter called "HMDSO"), thereby a film of HMDSO is formed on a substrate 8 made of polyimide.

As shown in Figure 1, during formation of the HMDSO film, the polyimide substrate (hereinafter simply called the substrate) 8 is first attached to the substrate holder 7. At this time, the material supply device 2, the exhaust device 14, and the HF electric power supply 11 are all placed in the stopped state. A magnetic filed 50 is constantly generated around the cathode 5 because the permanent magnet 10 is mounted on the rear surface of the cathode 5. Then, the exhaust device 14 is activated to evacuate the air in the vacuum chamber 1 through the exhaust passageway 4 to such an extent that the inside of the chamber is brought into a predetermined vacuum state (for example 5.0 x 10⁻³ Pa).

After evacuation of the air from the chamber, O₂ gas as a plasma source is introduced into the vacuum chamber 1 from the material supply device 2 via the supply passageway 3. Here, in the film formation system, the pressure level of the plasma source O₂ gas in the chamber determines whether a plasma generated inside the chamber is to be used for magnetron sputtering or for plasma polymerization. Hereinbelow, a state of a plasma used for magnetron sputtering is called a metallic-mode. On the other hand, a state of a plasma used for polymerization reaction is called a reactive-mode.

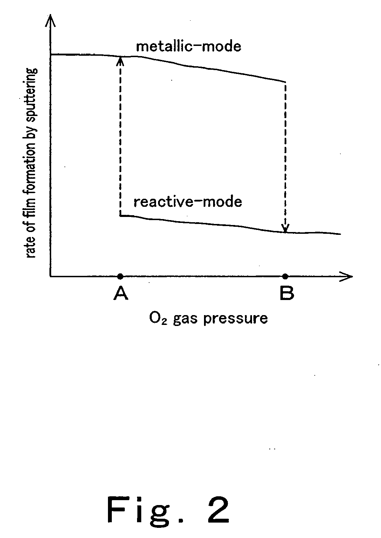

Figure 2 is a diagram schematically showing the relationship between the pressure of O₂ gas in the chamber and the rate of film formation by magnetron sputtering in the chamber. As shown in Figure 2, if the O₂ gas pressure in the chamber is lower than or equal to a predetermined pressure level *A* (for example, 2.0 x 10⁻¹ Pa), a metallic-mode plasma is generated in the chamber. As a result, the Cu forming the cathode 5 is sputtered by the plasma, thereby forming a Cu film on the substrate surface. On the other hand, if the O₂ gas pressure is higher than or equal to a predetermined pressure level B (for example, 5.0 Pa), a reactive-mode plasma is generated in the chamber. As a result, the cathode 5 will not be sputtered, and only a plasma polymerization process is carried out using the plasma. In addition, if the O₂ gas pressure falls between the predetermined pressure level *A* and the predetermined pressure level B (for example between 2.0 x 10⁻¹ and 5.0 Pa), the generated plasma might take both a metallic-mode and a reactive-mode.

As just described above, the selection of film formation methods is made according to the level of the plasma source O₂ gas pressure, in view of which, here, the O₂ gas pressure in the chamber is controlled to be higher than or equal to the predetermined pressure level B so that film formation by plasma polymerization is carried out in the chamber. In embodiment 1, the O₂ gas pressure in the chamber is controlled by letting the control unit 25 control the material supply device 2 which is working as a supply source of O₂ gas, thereby to control the supply flow rate of O₂ gas being supplied into the chamber. In addition to such O₂ gas supply flow rate adjustment, there are other ways for adjustment of the O₂ gas relative pressure. For example, the degree of vacuum in the chamber is adjusted by controlling the exhaust device 14, thereby to adjust the relative pressure of O₂ gas in the chamber. By virtue of such adjustment of the O₂ gas pressure in the chamber, it becomes possible to generate a reactive-mode plasma in the film formation system, as will be described later.

Next, the substrate holder 7 is rotated to cause the polyimide substrate 8 to rotate. At the same time, the HF electric power supply 11 is activated, whereby a high frequency voltage which is higher than or equal to 20 kHz and lower than 350 kHz is applied through cables to the cathode 5 and the vacuum chamber 1. This generates a glow discharge between the cathode 5 and the vacuum chamber 1, and the O₂ gas in the vacuum chamber 1 ionizes into ions and electrons and, as a result, a reactive-mode plasma is generated.

Next, film formation by plasma polymerization is carried out by making use of the reactive-mode plasma. In a film formation by plasma polymerization process, a plasma is firstly generated and maintained, and HMDSO gas as a reactive raw material for plasma polymerization is introduced from the material supply device 2 into the chamber through the supply passageway 3, In the chamber which has been supplied with the HMDSO gas, the following plasma polymerization reaction will proceed.

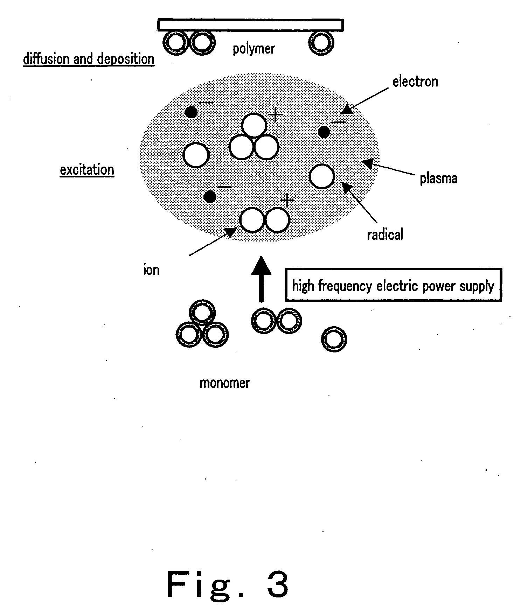

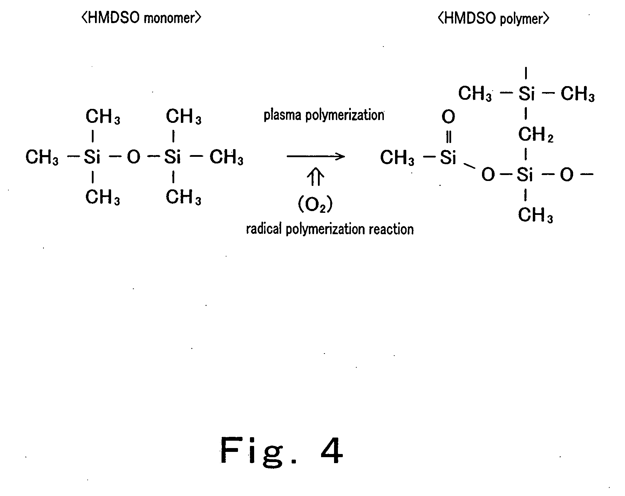

Figure 3 is a diagram schematically showing how plasma polymerization reaction of HMDSO proceeds. Figure 4 is a reaction formula of the polymerization. As shown in Figures 3 and 4, HMDSO monomer particles are excited by the plasma, and are ionized and radicalized (activated). The radicalized HMDSO monomers undergo a radical polymerization reaction and then form an HMDSO polymer. This HMDSO polymer diffuses on the surface of the substrate 8, and is deposited thereon. As a result, a film of HMDSO made of the HMDSO polymer is formed on top of the substrate 8. In this radical polymerization reaction, polymerization proceeds in the HMDSO main chain direction (lateral direction) as well as in the HMDSO branched chain direction (longitudinal direction). Accordingly, the polymerization process proceeding in both directions (longitudinal and lateral) causes the generated HMDSO film to achieve a high strength even if the film thickness is small.

During the time of the above polymerization process, a magnetic field 50 is generated around the cathode 5 by the permanent magnet 10. Because of this, electrons 51 of the plasma are trapped by the magnetic field 50. Concurrently with this, the ions gather together, and the ion concentration increases. As a result, the plasma density increases. This effectively accelerates ionization and radicalization of the polymerization raw material, thereby effectively improving the rate of film formation by plasma polymerization in comparison with the case where no magnetic field is generated. Accordingly, in the film formation system of the present embodiment, improvement in the production tact time is accomplished effectively. Besides, in accordance with the configuration of the present embodiment, it is possible to accomplish high film formation rates even when the level of voltage applied to the cathode 5 is low, thereby realizing high manufacturing efficiency.

In the above-described case, film formation by plasma polymerization is carried out using HF (i.e. a high frequency between 20 kHz and 350 kHz). Alternatively, the film formation by plasma polymerization may also be carried out using a high frequency of RF (i.e. 13.56 MHz).

### Embodiment 2

A film formation system according to a second embodiment of the present invention has the same configuration as that of the film formation system of embodiment 1. Therefore, the present embodiment will be described by making reference to Figure 1. In the film formation system of the present embodiment, plasma polymerization is carried out in the same way as in the film formation system of embodiment 1. In addition, in the film formation system of the present embodiment, film formation by magnetron sputtering is carried out by generating a metallic-mode plasma in the chamber, as described below.

To sum up, at the time of film formation by plasma polymerization, the pressure of O₂ gas in the chamber is controlled to be higher than or equal to the predetermined pressure level B so that a reactive-mode plasma is generated, as previously described in embodiment 1. By the use of the plasma thus generated, film formation by plasma polymerization is conducted to form a film of HMDSO. On the other hand, at the time of film formation by magnetron sputtering, the supply of HMDSO is stopped and the pressure of O₂ gas in the chamber is controlled to be lower than or equal to the predetermined pressure level *A* so that a plasma generated in the chamber becomes in the metallic-mode (see Figure 2). Here, for example, the adjustment of the O₂ gas pressure is carried out by controlling the material supply device 2 by the control unit 25 to adjust the O₂ gas supply flow rate to the chamber to become lower than the O₂ gas supply flow rate at the time of film formation by plasma polymerization.

By use of the metallic-mode plasma generated in the chamber as described above, a film is formed by magnetron sputtering. In this embodiment, the cathode 5, formed by Cu, functions not only as an electrode but also as a target for the magnetron sputtering. Details of the magnetron sputtering is described as follows. The electrons 51 of the metallic-mode plasma are trapped by the magnetic field 50 generated around the cathode 5. Concurrently with this, the ions gather together around the cathode 5, and the plasma density increases. And these ions collide with the cathode 5 (the target), and Cu atoms are sputtered from the cathode 5. These Cu atoms are diffused and deposited on the substrate surface to form a film of Cu thereon.

As described above, the film formation system according to the present embodiment is applicable both to the film formation by plasma polymerization and to the film formation by magnetron sputtering, and makes it possible to accomplish high film formation rates in both of the film formations. It is noteworthy that, in the present embodiment, film formation methods can be switched easily by adjustment of the O₂ gas pressure in the chamber, thereby making it unnecessary to provide a complicated configuration.

The film formation system of the present embodiment is effective for the case where only film formation by plasma polymerization is carried out as well as for the case where only film formation by magnetron sputtering is carried out. However, the film formation system of the present embodiment is effective particularly for the case where film formation by plasma polymerization and film formation by magnetron sputtering are carried out alternately including the case where a film of HMDSO and a film of Cu are formed alternately on the surface of the substrate 8. In this case, film formation by plasma polymerization and film formation by magnetron sputtering can be carried out alternately by a single system, thereby making it unnecessary to provide an inter-device substrate transfer step which is required in the case where film formation by plasma polymerization and film formation by magnetron sputtering are carried out by different devices. Therefore, it becomes possible to accomplish further improvement in the production tact time, reduction in the system cost, and reduction in the system size. Furthermore, the cathode 5 is used in common for both film formation by plasma polymerization and film formation by magnetron sputtering, so that cruds adhered to the cathode 5 at the time of film formation by plasma polymerization are removed therefrom at the time of film formation by magnetron sputtering. This prevents the cruds, adhered to the cathode 5 during film formation by plasma polymerization, from influencing on the electrode, thereby making it possible to maintain favorable electrode characteristics.

### Embodiment 3

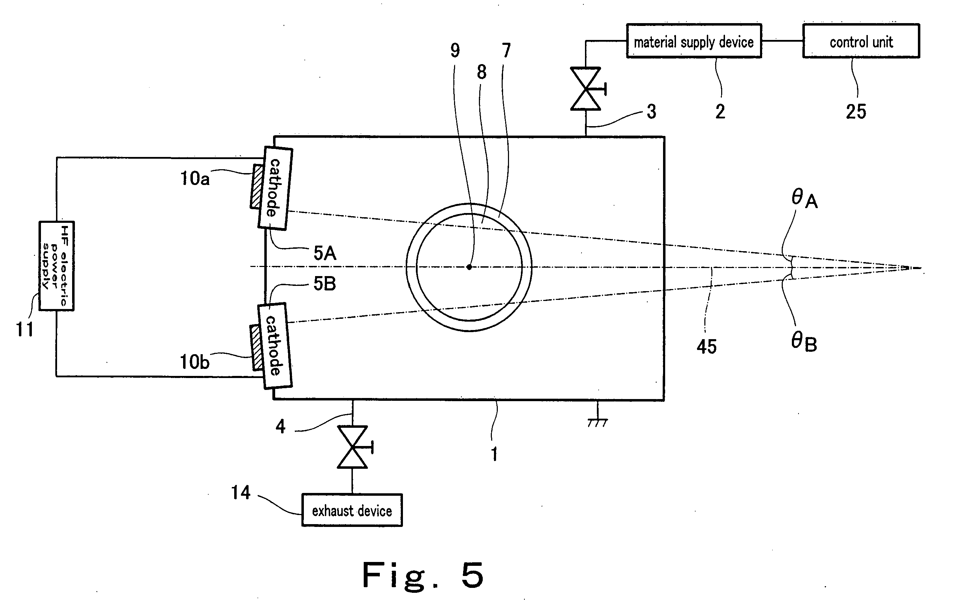

Figure 5 is a diagram schematically showing a configuration of a film formation system according to embodiment 3 of the present invention. The film formation system of the present embodiment has the similar structure as that of the film formation system of embodiment 1, but they are different with regard to the point that the film formation system of the present embodiment is provided with a pair of cathodes.

More specifically, the film formation system of the present embodiment has a pair of cathodes 5A and 5B formed of Cu, wherein a portion of each of the cathodes 5A and 5B is disposed within the chamber and the rest projects outwardly from the chamber. The cathodes 5A and 5B are insulated from the vacuum chamber 1 by an insulating member. The cathodes 5A and 5B are arranged so that their positions are symmetrical relative to the extension line 45 of the diameter of the substrate holder 7 and normal lines of the principal surfaces of the cathodes 5A and 5B run at predetermined angles (θ*A*, θ*B*) with the extension line 45. The tilt angles (θ*A*, θ*B*) of the cathodes 5A and 5B are set to optimum angles for film formation by plasma polymerization as well as for film formation by magnetron sputtering, an example of which is about 15 degrees. Each of the cathodes 5A and 5B is connected, through a cable, to the common HF electric power supply 11. In the present embodiment, a pair of output terminals of the HF electric power supply 11 is insulated from ground (earth terminal). In addition, permanent magnets 10a and 10b are mounted on a rear surface of the cathode 5A and on a rear surface of the cathode 5B, respectively.

Film formation by plasma polymerization by the film formation system of the present embodiment is carried out in the similar manner as in embodiment 1, but the present embodiment differs from embodiment 1 with respect to the following points. During the time of film formation by plasma polymerization of the present embodiment, a high frequency voltage is supplied from the HF electric power supply 11 to the cathodes 5A and 5B through the cables. Thereby, the cathodes 5A and 5B are activated oppositely in polarity to each other at each discharge, and function alternately as a negative and positive electrode. There occurs a glow discharge between the cathode 5A and the cathode 5B and, as a result, a reactive- mode plasma is generated. The reactive-mode plasma causes only film formation by plasma polymerization, thereby forming an HMDSO film.

Here, as described above, the cathodes 5A and 5B are activated oppositely in polarity to each other in the film formation system of the present embodiment. This increases the amount of electric power supplyable to the HF electric power supply 11, in comparison with the case where only a single cathode is provided. Accordingly, it becomes feasible to increase the amount of electric power supplied to the HF electric power supply 11, thereby making it possible to effectively improve the rate of film formation during the film formation by plasma polymerization. Therefore, it becomes possible to further reduce the time required for film formation. Accordingly, in addition to the effects described in embodiment 1, it becomes possible to accomplish further improvement in the production tact time without making a great change in system configuration. Furthermore, by virtue of the use of a pair of cathodes (i.e., the cathodes 5A and 5B), sputtering of insulator material becomes possible.

In addition, in the film formation system of the present embodiment, the O₂ gas pressure in the chamber is controlled to generate a metallic-mode plasma in the chamber in a manner as previously described in the second embodiment, thus it is possible to carry out film formation by magnetron sputtering using the cathodes 5A and 5B as targets. During such film formation by magnetron sputtering, the cathodes 5A and 5B are activated oppositely in polarity to each other at each discharge, and function alternately as a negative electrode and a positive electrode. There occurs a magnetron discharge between the cathodes 5A and 5B and, as a result, a metallic-mode plasma is generated. The metallic-mode plasma is used to sputter the cathodes 5A and 5B, thereby film formation by magnetron sputtering is performed, and a film of Cu is formed. As in the aforesaid film formation by plasma polymerization, also in this film formation by magnetron sputtering, the amount of electric power supplyable to the HF electric power supply 11 increases, in comparison with the case where only a single cathode is provided, because of the provision of a pair of cathodes (i.e., the cathodes 5A and 5B). Accordingly, it becomes feasible to increase the supply amount of electric power to the HF electric power supply 11, as a result of which it becomes possible to effectively accomplish improvement in the rate of film formation at the time of film formation by magnetron sputtering.

As just described, the film formation system of the present embodiment is able to provide the same effects as described in embodiment 2. At the same time, it employs a pair of cathodes (i.e., the cathodes 5A and 5B), thereby making it possible to achieve higher film formation rates in both of the film formation methods (film formation by plasma polymerization and film formation by magnetron sputtering). Therefore, the time required for film formation is reduced further, thereby accomplishing further improvement in the production tact time, in comparison with the case where only a single cathode is provided.

As a modification example of the present embodiment, it may be arranged such that the cathodes 5A and 5B as targets are formed of different materials. In this case, it becomes feasible to form a multi-element film containing different elements by means of magnetron sputtering.

### Embodiment 4

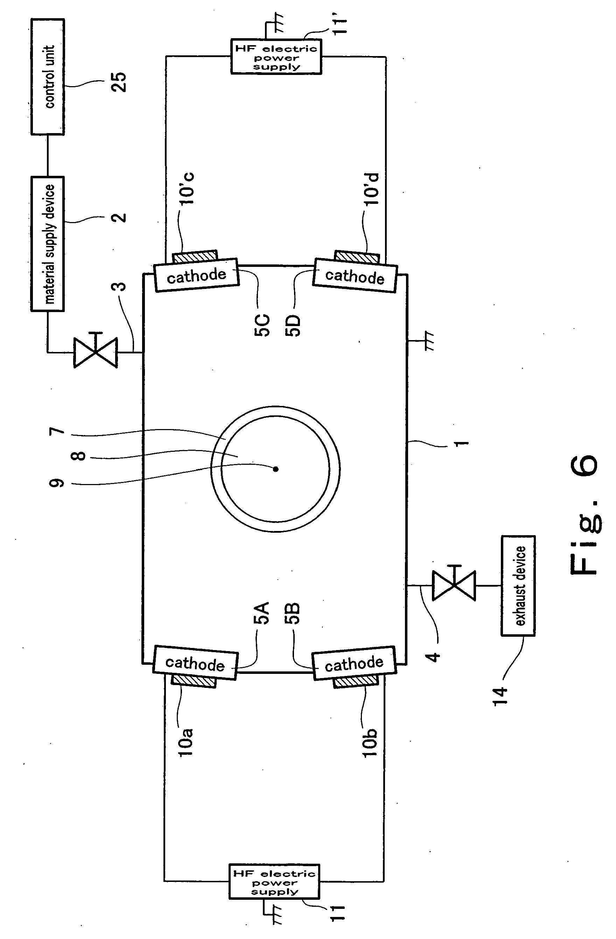

Figure 6 is a diagram schematically showing a configuration of a film formation system according to embodiment 4 of the present invention. As shown in Figure 6, the film formation system of the present embodiment has the same configuration as the film formation system of embodiment 3 provided with a pair of cathodes. However, the present embodiment differs from embodiment 3 in that a plurality of sets of cathode pairs are provided.

More specifically, in the film formation system of the present embodiment, in addition to the HF electric power supply 11 to which the cathodes 5A and 5B are connected, a high frequency (HF) electric power supply 11' is disposed outside the vacuum chamber 1, and a pair of cathodes 5C and 5D is connected to the HF electric power supply 11'. These cathodes 5A-5D are made of Cu and are provided, on their rear surfaces, with permanent magnets 10a, 10b, 10'c, 10'd, respectively.

The cathode 5C and the cathode 5D are disposed symmetrically relative to the aforesaid extension line 45 of the diameter of the substrate holder 7 which is an axis of symmetry of the cathodes 5A and 5B. And, like the cathodes 5A and 5B, a portion of each of the cathodes 5C and 5D is disposed within the chamber and the rest projects outwardly from the chamber. In addition, normal lines of the principal surfaces of the cathodes 5C and 5D run at predetermined angles with the extension line 45. The tilt angles of the cathodes 5C and 5D are set to optimum values for film formation by plasma polymerization as well as for film formation by magnetron sputtering, for example, an angle of about 15 degrees. In the present embodiment, the tilt angles of the cathodes 5A and 5B are equal to those of the cathodes 5C and 5D. In addition, the cathodes 5C and 5D are isolated from the vacuum chamber 1 by insulating members. And, each of the cathodes 5C and 5D is connected, through a cable, to the HF electric power supply 11'.

The cathodes 5A and 5C are symmetrical relative to an extension line of the diameter of the substrate holder 7 normal to the axis of symmetry of the cathodes 5C and 5D. Furthermore, the cathodes 5B and 5D are symmetrical relative to the aforesaid axis of symmetry of the cathodes 5A and 5C. Therefore, the pair of the cathodes 5A and 5B and the pair of the cathodes 5C and 5D are disposed face to face with each other across the substrate holder 7.

In the film formation system of the present embodiment, film formation by plasma polymerization is carried out in the following way. In the first place, during film formation by plasma polymerization, a high frequency voltage is applied, through the cables, to the cathodes 5A and 5B from the HF electric power supply 11, and the cathodes 5C and 5D are fed a high frequency voltage from the HF electric power supply 11' through the cables. Consequently, the cathodes 5A and 5B are activated oppositely in polarity to each other, and function alternately as a discharge positive electrode and as a discharge negative electrode. There occurs a glow discharge between the cathodes 5A and 5B, thereby generating a reactive-mode plasma. Furthermore, the cathodes 5C and 5D are activated oppositely in polarity to each other, and function alternately as a discharge positive electrode and as a discharge negative electrode. There occurs a glow discharge between the cathodes 5C and 5D, thereby generating a reactive-mode plasma. And, film formation by plasma polymerization is carried out using these reactive-mode plasmas, thereby to form a film of HMDSO. In such film formation by plasma polymerization, it becomes possible to increase the supply amount of electric power to the HF electric power supply 11 because of the provision of the pair of the cathodes 5A and 5B, as described in embodiment 3. Likewise, it becomes possible to increase the supply amount of electric power to the HF electric power supply 11' because of the provision of the pair of the cathodes 5C and 5D. Because of this, in film formation by plasma polymerization employing a plurality of sets of cathode pairs, it becomes possible to accomplish further improvement in the rate of film formation. For example, it becomes possible to deposit films having a greater thickness in a short period of time.

Furthermore, in the film formation system of the present embodiment, it is possible to carry out film formation by magnetron sputtering targeted at the cathodes 5A-5D in the following way, as described in the third embodiment. More specifically, during film formation by magnetron sputtering in the film formation system of the present embodiment, the cathodes 5A and 5B are activated oppositely in polarity to each other, and function alternately as a discharge negative electrode and as a discharge positive electrode, as in the aforesaid film formation by plasma polymerization. Thereby, there occurs a magnetron discharge between the cathodes 5A and 5B, as a result of which a metallic-mode plasma is generated. In addition, the cathodes 5C and 5D are activated oppositely in polarity to each other, and function alternately as a discharge negative electrode and as a discharge positive electrode. Thereby, there occurs a magnetron discharge between the cathodes 5C and 5D, as a result of which a metallic-mode plasma is generated. The cathodes 5A-5D, as the targets, are subjected to magnetron sputtering by making use of the metallic-mode plasmas. And, a film of Cu is formed by such sputtering. In such magnetron sputtering, the provision of the pair of the cathodes 5A and 5B makes it possible to increase the supply amount of electric power to the HF electric power supply 11, as described in embodiment 3. Furthermore, the provision of the pair of the cathodes 5C and 5D makes it possible to increase the supply amount of electric power as well.. To sum up, in the film formation by magnetron sputtering employing a plurality of sets of cathode pairs, it becomes possible to accomplish further improvement in the rate of film formation.

As just descried, since the film formation system of the present embodiment employs cathode pairs, the same effects as described in embodiment 3 are obtained. Additionally, a plurality of sets of cathode pairs are employed in the present embodiment, thereby making it possible to achieve higher film formation rates for the film formation by plasma polymerization as well as for the film formation by magnetron sputtering. Therefore, the time required for film formation is further reduced and further improvement in the production tact time is accomplished.

So far, the description has been made in terms of the case where two sets of cathode pairs are disposed. Alternatively, it may be arranged such that two or more sets of cathode pairs are disposed. In addition, as a modification example of the present embodiment, the cathodes 5A-5D may be formed of different materials. In this case, it is possible to deposit either a multi-element film containing different elements or a multilayered film comprising the laminating together of films of different materials, by means of film formation by magnetron sputtering.

The positions, at which cathodes are arranged, are not limited to those described in embodiments 1 to 4. In addition, the description has been made in terms of the arrangement in which the substrate holder 7 is disposed and the substrate 8 is attached to the substrate holder 7 in embodiments 1 to 4). Alternatively, it may be arranged such that a rotational shaft is mounted directly to the substrate 8 so that the substrate 8 is made rotatable without the provision of the substrate holder 7.

### Embodiment 5

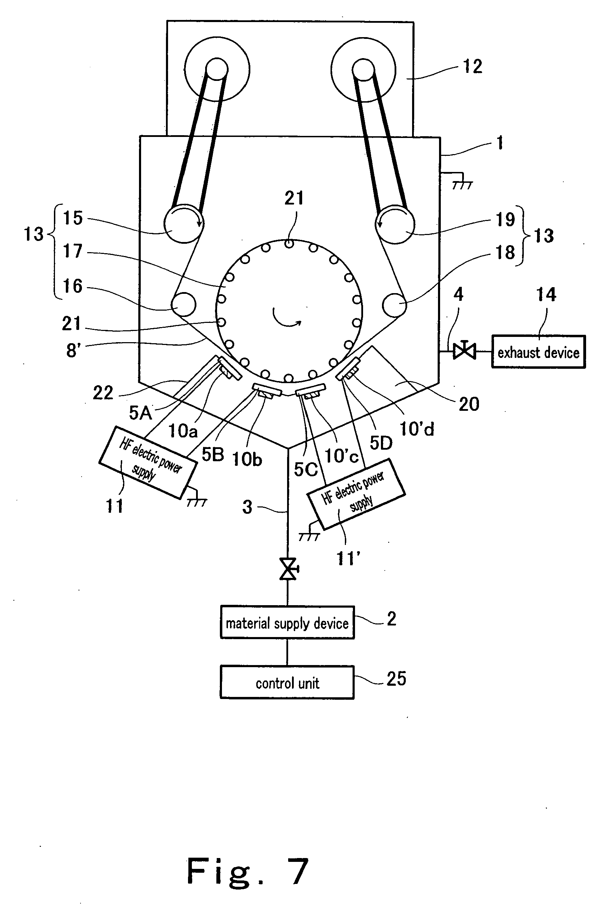

Figure 7 is a side cross sectional view schematically showing a configuration of a film formation system according to embodiment 5 of the present invention. As shown in Figure 7, the film formation system of the present embodiment is a roll coater type system provided with two sets of cathode pairs, and comprises: a vacuum chamber 1 in which is disposed a substrate transfer structure 13; a rotary drive device 12 which drives the substrate transfer structure 13 to rotate; a material supply device 2 and a supply passageway 3 for supplying a film formation raw material and plasma source gas into a reaction space 20 in the chamber; a control unit 25 which controls the material supply device 2; an exhaust device 14 and an exhaust passageway 4 for evacuating the air in the vacuum chamber; and a HF electric power supply 11 and 11' to which a pair of cathodes 5A and 5B and a pair of cathodes 5C and 5D, both disposed in the reaction space 20, are respectively connected through cables. The HF electric power supplies 11 and 11' and the vacuum chamber 1 are grounded.

The inside of the vacuum chamber 1 is divided by a partition wall 22. Thereby, the reaction space 20 is formed. The reaction space 20 is connected to the material supply device 2 via the supply passageway 3, and the two cathode pairs 5A, 5B and 5C, 5D are disposed in the reaction space 20. In the reaction space 20, film formation by plasma polymerization is carried out, as will be described below. Each of the cathodes 5A-5D arranged in the reaction space 20 is composed of Cu, and is shaped like a rectangle extending along the axis of rotation of a below-mentioned cam roll 17. The cathodes 5A-5D are arranged along the roll surface of the cam roll 17. The cathodes 5A-5D are arranged along rolling direction of the cam roll 17 and, for example, supported on the side wall of the chamber 1 by a supporting structure (not shown). Permanent magnets 10a, 10b, 10'c, and 10'd are mounted on the rear surfaces of the cathodes 5A-5D (i.e., the surfaces of the cathodes 5A-5D opposite to the cam roll 17), respectively. Although any particular limitation is not set as for the arrangement of the permanent magnets 10a, 10b, 10'c, and 10'd, it is preferable that the magnets are disposed so that lines of magnetic force capable of increasing the plasma density by efficiently trapping electrons in a plasma are formed around the cathodes 5A-5D.

Furthermore, the substrate transfer structure 13, for distributing a film-like continuous substrate 8' winded around a roll to the reaction space 20, is provided in the chamber. More specifically, the substrate transfer structure 13 comprises: a supply roll 15 which rotates so that the substrate 8' is transferred to the reaction space 20; a supply side guide roll 16 which is rotatable and guides the substrate 8' forwarded from the supply roll 15 to the cam roll 17; the cam roll 17 which is rotatable and disposed opposite to the reaction space 20 and which contact-supports the substrate 8' from the rear surface (i.e., the surface on the opposite side of a film formation surface of the substrate 8') so that the film formation surface of the substrate 8' is disposed face to face with the cathodes 5A-5D; a rotatable take-up side guide roll 18 which horizontally faces the supply side guide roll 16 over the cam roll 17 and guides the substrate 8' passed through the cam roll 17 to a take-up roll 19; and the take-up roll 19 which horizontally faces the supply roll 15 across the cam roll 17 and which rotates so that the substrate 8' is rolled up.

The supply roll 15 is identical in shape with the take-up roll 19, and the supply side guide roll 16 is identical in shape with the take-up side guide roll 18. The cam roll 17 has a large diameter correspondingly to the reaction space 20, thereby to increase the facing area of the reaction space 20 and the substrate 8'. In addition, the supply roll 15 and the take-up roll 19 are connected to the rotary drive device 12 disposed outside the chamber. The rotary drive device 12 is provided with a motor (not shown), and by control of the rotation of the motor, the rotation of the supply roll 15 and the take-up roll 19 is controlled. Thereby, the transfer speed and the tension of the substrate 8' are adjusted. The supply side guide roll 16, the take-up side guide roll 18, and the cam roll 17 rotate according to the movement of the substrate 8' which is conveyed by rotation of the supply roll 15 and the take-up roll 19. Cooling coils 21 for cooling the substrate 8' are arranged within the cam roll 17. Each of these rolls 15-19 comprises an insulating member, and the both ends are supported, for example by a supporting structure (not shown), on the side wall of the vacuum chamber 1. Each of the rolls 15-19 is arranged so that the axis of rotation thereof becomes horizontal.

Next, a film formation by plasma polymerization process by means of the film formation system of the present embodiment will be described. More specifically, film formation by plasma polymerization is carried out as follows. In the first place, the substrate 8' is provided around the supply roll 15. Then, the substrate 8' is laid so as to extend between the supply roll 15 and the take-up roll 19 through the supply side guide roll 16, the cam roll 17, and the take-up side guide roll 18. At this time, the material supply device 2, the exhaust device 14, the HF electric power supply 11, the HF electric power supply 11' are all placed in the stopped state. Then, the exhaust device 14 is activated for evacuation of the air in the chamber through the exhaust passageway 4, and the inside of the chamber is brought into a predetermined vacuum state (for example, 5.0 x10⁻³ Pa).

Then, a supply of O₂ gas as a plasma source is provided from the material supply device 2 to the reaction space 20 through the supply passageway 3. Here, in order to generate a reactive-mode plasma for plasma polymerization (as mentioned above), the control unit 25 controls the material supply device 2 for adjustment of the O₂ gas supply flow rate, whereby the O₂ gas pressure in the reaction space 20 becomes higher than or equal to the predetermined pressure level *B*.

Next, the HF electric power supply 11 and the HF electric power supply 11' are activated, and each of the cathodes 5A-5D is fed a high frequency voltage via a respective cable. Thereby, in the reaction space 20, glow discharges are generated between the cathodes 5A and 5B and between the cathodes 5D and 5C, whereby reactive-mode plasmas are generated. And, under the existence of the plasma, HMDSO gas is supplied by the material supply device 2 to the reaction space 20 through the supply passageway 3. And, the rotary drive device 12 is activated, thereby causing the supply roll 15 and the take-up roll 19 to rotate, as a result of which the substrate 8' is continuously conveyed from the supply roll 15 towards the take-up roll 19.

As mentioned above, since a reactive-mode is being generated in the reaction space 20, film formation by plasma polymerization is carried out by supplying HMDSO gas to the reaction space 20. Thereby, a film of HMDSO is formed on surface of the substrate 8' passing through the reaction space 20. And, the substrate 8' is continuously supplied, by the substrate transfer structure 13, to the reaction space 20 where film formation by plasma polymerization is carried out. This makes it possible to continuously deposit a film of HMDSO on the film-like substrate 8'.

Here, the above-described arrangement in which continuous film formation is carried out by the use of the substrate transfer structure 13 (more specifically the roll coater type arrangement) is inapplicable unless the rate of film formation at the time of plasma polymerization in the reaction space 20 is high. However, in the film formation system of the present embodiment, as mentioned in embodiment 4, improvement in the rate of film formation is accomplished by the permanent magnets 10a, 10b, 10'c, and 10'd mounted on the rear surfaces of the cathodes 5A-5D, and by the use of a plurality of sets of cathode pairs, thereby making it possible to make such an arrangement applicable. And, since such continuous film formation is attained in the way described above, improvement in the efficiency of manufacture is accomplished effectively by the film formation system of the present embodiment.

Furthermore, in addition to the above-described film formation by plasma polymerization, it is possible for the film formation system of the present embodiment to carry out film formation by magnetron sputtering, as in embodiment 4. For example, the substrate 8' on which a film of HMDSO has been formed continuously by the aforesaid film formation by plasma polymerization is once rolled up by the take-up roll 19, and after that, the substrate 8' is again arranged around the supply roll 15. In this case, the substrate 8' is mounted on the supply roll 15 so that the surface carrying thereon the HMDSO film is situated face to face with the reaction space 20. And, after activating the exhaust device 14 to evacuate the air in the chamber, the raw material supply device 2 is made active to provide a supply of O₂ gas to the chamber. More specifically, film formation by magnetron sputtering is carried out as follows. The material supply device 2 is controlled by the control unit 25 so that a metallic-mode plasma is generated in the reaction space 20, and the supply flow rate of O₂ gas is controlled so that the O₂ gas pressure in the reaction space 20 becomes lower than or equal to the predetermined pressure level *A*.

Then, the HF electric power supply 11 and the HF electric power supply 11' are activated and a high frequency voltage is applied to each of the cathodes 5A-5D via a respective cable. Thereby, in the reaction space 20, a magnetron discharge occurs between the cathodes 5A and 5B and between the cathodes 5C and 5D, as in embodiment 4, and a metallic-mode plasma is generated. And, under such a plasma generation state, the rotary drive device 12 is operated to cause the supply roll 15 and the take-up roll 19 to rotate, whereby the substrate 8' is continuously conveyed from the supply roll 15 towards the take-up roll 19. In the reaction space 20, the cathodes 5A-5D are sputtered as targets by the metallic-mode plasma. Thereby, a film of Cu is formed on the aforesaid HMDSO film by magnetron sputter film formation. And, the substrate 8' is continuously supplied to the reaction space 20 where film formation by magnetron sputtering is carried out, thereby making it possible to continuously form a film of Cu on the film-like substrate 8'.

Here, as described above in embodiment 4, in the system arrangement, in which the permanent magnets 10a, 10b, 10'c, and 10'd are mounted on the rear surfaces of the cathodes 5A-5D and a plurality of sets of cathode pair 5A-5B and 5C-5D, are disposed, improvement in the rate of film formation is accomplished effectively in the above-mentioned film formation by magnetron sputtering, therefore making it possible to employ a roll coater type configuration which requires a high film formation rate. And, in such a roll coater-type film formation system, it becomes possible to continuously form a film on the film-like substrate 8'. Therefore, improvement in the manufacturing efficiency is accomplished effectively.

As has been mentioned above, in accordance with the film formation system of the present embodiment, it becomes possible to carry out a film formation by plasma polymerization process and a film formation by magnetron sputtering process by making use of the same apparatus, and to realize a high film formation rate in both of these processes. In particular, with such a roll coater-type configuration, it is possible to continuously supply the substrate 8' to the reaction space 20 by the substrate transfer structure 13 and to carry out film formation, thereby making it possible to realize high manufacturing efficiency.

The above description has been made in terms of the case where film formation by plasma polymerization or film formation by magnetron sputtering is performed by simultaneously using two pairs of cathodes 5A-5B and 5C-5D. In addition to this, as a modification example of the present embodiment, it may be arranged such that the pair of the cathodes 5A and 5B, located upstream relative to a direction in which the substrate 8' is transferred, is used to form a film of HMDSO by plasma polymerization, while at the same time the pair of the cathodes 5C and 5D located downstream relative to the substrate transfer direction is used to form, by magnetron sputtering, a film of Cu on the HMDSO film on the substrate 8' conveyed from the upstream side (i.e., from the side of the cathodes 5A and B). Hereinbelow, the modification example will be described in detail.

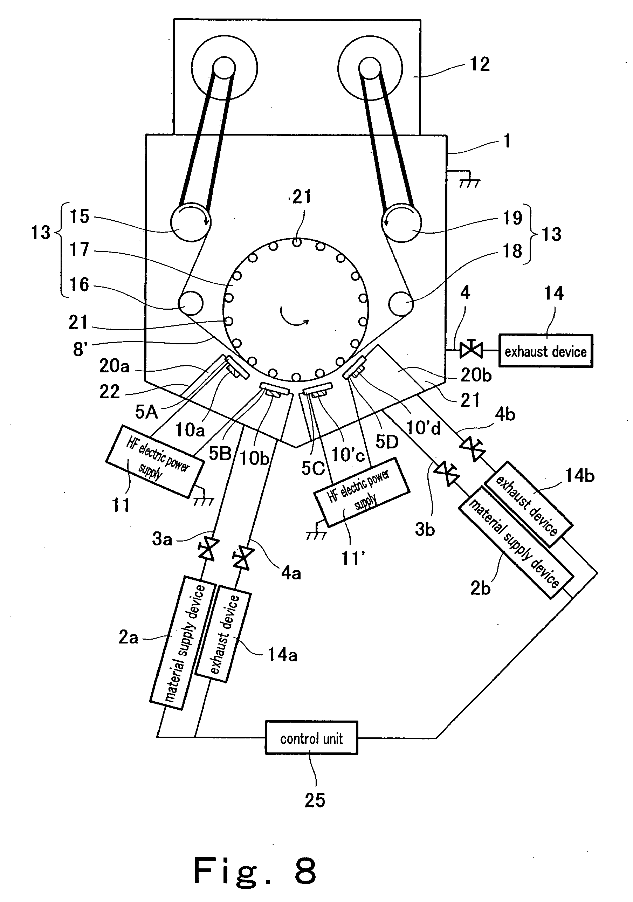

Figure 8 is a side cross sectional view schematically showing a configuration of a film formation system according to the modification example of the present embodiment. As shown in Figure 8, the film formation system of the present modification example has the similar configuration as that of the film formation system of Figure 7, but there are the following differences between these two systems. That is, in the present modification example, a first reaction space 20a located upstream relative to the substrate transfer direction and a second reaction space 20b located downstream relative to the substrate transfer direction are provided in the chamber, and a pair of cathodes 5A and 5B is arranged in the first reaction space 20a, and another pair of cathodes 5C and 5D is arranged in the second reaction space 20b. Furthermore, in addition to the exhaust device 14 and the exhaust passageway 4 for evacuation of the entire chamber, an exhaust device 14a and an exhaust passageway 4a for evacuation of the first reaction space 20a, and an exhaust device 14b and an exhaust passageway 4b for evacuation of the second reaction space 20b are provided. As the exhaust devices 14a and 14b, turbo-molecular pumps et cetera are used. Furthermore, a material supply device 2a and a supply passageway 3a configured to supply HMDSO and O₂ gas to the first reaction space 20a, and a material supply device 2b and a supply passageway 3b configured to supply O₂ gas to the second reaction space 20b are provided. And, the material supply devices 2a and 2b and the exhaust devices 14a and 14b are all controlled by the control unit 25.

In accordance with the film formation system of the above-mentioned configuration, it is possible to adjust the pressure of O₂ gas in the first reaction space 20a and the pressure of O₂ gas in the second reaction space 20b independently via the following way, thereby making it possible to generate a reactive-mode plasma in the first reaction space 20a and a metallic-mode plasma in the second reaction space 20b. In the system of the present modification example, the first and second reaction spaces 20a and 20b are provided with the exhaust devices 14a and 14b respectively, and the exhaust devices 14a and 14b are controlled independently by the control unit 25, thereby making it possible to control the degree of vacuum for each reaction space independently. In addition, the first and second reaction spaces 20a and 20b are provided with the material supply devices 2a and 2b respectively, and the material supply devices 2a and 2b may be controlled independently by the control unit 25, thereby making it possible to control the supply flow rate of O₂ gas for each reaction space independently. To sum up, each of the degree of vacuum and the supply flow rate of O₂ gas is independently regulated for the first and second reaction spaces 20a and 20b, whereby the pressure of O₂ gas in each of the first and second reaction spaces 20a and 20b may be controlled independently. Therefore, here, the pressure of O₂ gas in the first reaction space 20a is adjusted to become higher than or equal to the predetermined pressure level B so that a reactive-mode plasma is generated. On the other hand, the pressure of O₂ gas in the second reaction space 20b is adjusted to become lower than or equal to the predetermined pressure level *A* so that a metallic-mode plasma is generated.

In accordance with the above configuration, a film of HMDSO is formed by plasma polymerization using a reactive-mode plasma in the first reaction space 20a, and, on the other hand, a film of Cu is formed by magnetron sputtering using a metallic-mode plasma in the second reaction space 20b. More specifically, the substrate 8' which has been carried through the first reaction space 20a is continuously supplied to the second reaction space 20b. In the second reaction space 20b, a film of Cu is formed on a film of HMDSO, which is formed on the substrate 8' in the first reaction space 20a. Therefore, in accordance with the film formation system of the present modification example, it becomes possible to form a multilayered film comprising a lamination of a film of HMDSO and a film of Cu by a single production line.

In the present embodiment and in its modification example, the arrangement of cathodes, such as the position of cathodes, the number of cathodes to be arranged, etcetera, is not limited to the above description. For example, cathodes may be arranged nearer to the center of the system than the substrate. In this case, films are formed on a surface of the substrate facing the cathodes. In addition, it is possible to employ a single cathode as in embodiment 1, instead of the provision of cathode pairs. Alternatively, two or more sets of cathode pairs may be disposed. Besides, two or more reaction spaces may be provided along the substrate transfer direction.

### Embodiment 6

As mentioned above, embodiment 3 is capable of achieving a high film formation rate. In embodiment 3, however, a problem arose that, when forming a film of aluminum in the metallic-mode, the formed film turned to yellow. More precisely, it is possible to form a film of aluminum without yellowing, but the range of conditions for film formation free from yellowing is narrow, thus yellowing is liable to occur due to deviations from such condition range.

The inventors of the present invention made a study on the cause of the aforesaid yellowing. And, from the fact that no yellowing occurs when forming a film by means of a conventional DC sputtering technique (in which a single cathode is employed, and let the cathode and vacuum chamber function as a negative electrode and a positive electrode respectively), and from the fact that yellowing occurs in embodiment 3, the inventors arrived at the conclusion that yellowing results from the difference in the configuration between the conventional film formation by DC sputtering and embodiment 3, i.e. the area of the positive electrode when generating an electric discharge is small. If the positive electrode area is small, this facilitates expression of the reactivity of the cathodes 5A and 5B when functioning as positive electrodes. This is suggested to be the cause of yellowing. Therefore, it is possible to avoid the occurrence of yellowing by enlarging the area of the positive electrode at the time of metallic-mode discharges.

Embodiment 6 of the present invention is an example of embodiment preventing such yellowing.

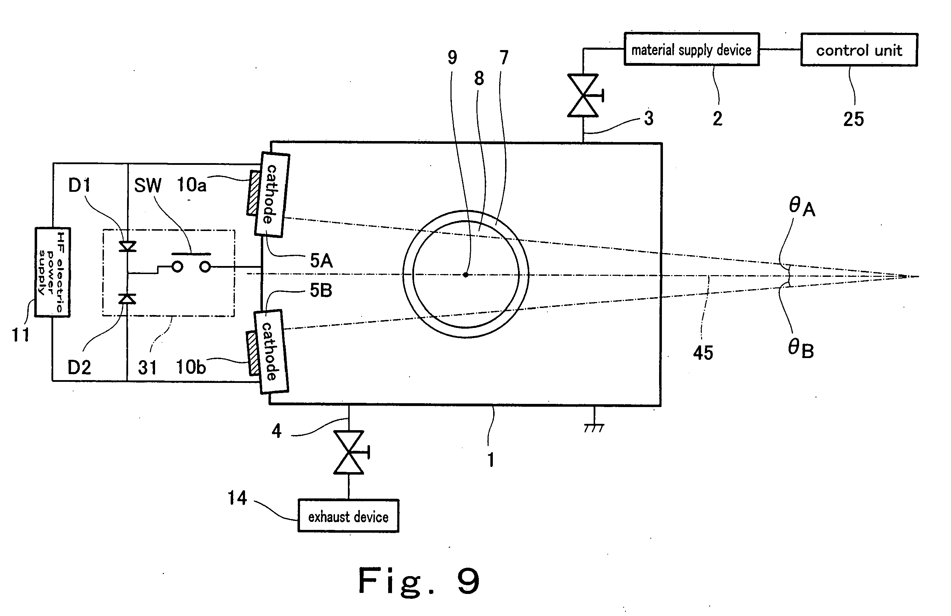

Figure 9 is a diagram schematically showing a configuration of a film formation system according to embodiment 6 of the present invention. In Figure 9, the same numerals as in Figure 5 represent the same or corresponding components.

Referring to Figure 9, in the present embodiment, a chamber connection circuit 31 is provided which establishes electrical connection between either one of the paired cathodes 5A or 5B, whichever functions as a positive electrode, and the vacuum chamber 1. Other parts of the configuration are the same as in embodiment 3.

The chamber connection circuit 31 is made up of a pair of diodes D1 and D2, and an on-off switch SW. More specifically, the p-side terminal of the diode D1 is connected to an interconnection wire between one of the output terminals of the HF electric power supply 11 and the cathode 5A, and the p-side terminal of the diode D2 is connected to an interconnection wire between the other output terminal of the HF electric power supply 11 and the cathode 5B. And, the n-side terminals of the diode D1 and the diode D2 are connected, through the on-off switch SW, to the vacuum chamber 1. The on-off switch SW is operated by manual operation or by an unshown control unit.

Next, the operation of the vacuum film formation system constructed as described above will be explained.

The on-off SW is maintained in the OFF state throughout the period of reactive-mode. Thereby, the cathodes 5A and 5B are electrically disconnected from the vacuum chamber 1.

On the other hand, the on-off switch SW is maintained in the ON state throughout the period of metallic-mode. And, a high frequency voltage is impressed to the cathodes 5A and 5B from the HF electric power supply 11. When the cathode 5A functions as a positive electrode while the cathode 5B functions as a negative electrode, the diode D1 is placed in the conducting state while the diode D2 is placed in the non-conducting state. As a result, the cathode 5A is brought into electrical connection with the vacuum chamber 1 while the cathode 5B is electrically disconnected from the vacuum chamber 1. Consequently, the cathode 5A and the vacuum chamber 1 function as a positive electrode, while on the other hand the cathode 5B functions as a negative electrode. Then, an electric discharge is generated between the positive electrode (i.e., the cathode 5A and the vacuum chamber 1) and the negative electrode (i.e., the cathode 5B).

On the other hand, when the cathode 5B functions as a positive electrode while the cathode 5A functions as a negative electrode, the diode D2 is placed in the conducting state while the diode D1 is placed in the non-conducting state. Thereby, the cathode 5B is brought into electrical connection with the vacuum chamber 1 while on the other hand the cathode 5A is electrically disconnected from the vacuum chamber 1. Consequently, the cathode 5B and the vacuum chamber 1 function as a positive electrode while the cathode 5A functions as a negative electrode, as a result of which an electric discharge is generated between the positive electrode (i.e., the cathode 5B and - the vacuum chamber 1) and the negative electrode (i.e., the cathode 5A).

To sum up, when the cathode 5A or the cathode 5B functions as a positive electrode, the vacuum chamber 1, too, functions as a positive electrode at the same time. Therefore, the area of the positive electrode becomes large at the time of metallic-mode discharges. Therefore, even when forming a film of aluminum, it is possible to prevent the yellowing of the film.

The configuration of the chamber connection circuit 31 is not limited to the above-mentioned one. Any configuration may be employed as long as it is able to electrically connect the cathode 5A or the cathode 5B, whichever functions as a positive electrode, to the vacuum chamber 1. For example, the chamber connection circuit 31 may be configured as follows. That is, the cathodes 5A and 5B are connected, through a pair of on-off switches SW, to the vacuum chamber 1, and these on-off switches SW are controlled to be on or off alternately according to the high frequency voltage polarity.

The permanent magnets of the above-mentioned embodiments 1-6 are mounted on the rear surfaces of the cathodes. Alternatively, permanent magnets may be arranged inside the cathodes. Furthermore, means for generating a magnetic field is not limited to the permanent magnet. For example, an electromagnet may be used. Preferably, magnetic field generating means, such as permanent magnet, electromagnet etcetera, are disposed so that eroded portions of the targets has a shape uniformly eroded.

In the above-mentioned embodiments 1-6, the description has been made in terms of the case where O₂ gas is used as a plasma source gas. However, not only O₂ gas but also Ar gas or other gas may be supplied as a plasma source gas. In this case, it becomes possible to select the plasma generation modes by regulating the pressure of the supplied plasma source gas.

In the above, the description has been made in terms of the case where a film of HMDSO is formed by plasma polymerization using the film formation system of the present invention. However, the film formation system of the present invention is effective also for the case where different plasma polymerized film, such as a film of an organosilicon compound comprising a plasma polymer of hexamethyldisilazane (HMDS), hexamethyldisilane (HMDSN), trimethoxysilane (TMS)) or the like, is formed. Besides, the film formation system of the present invention is effective not only for formation of a film of Cu by means of film formation by magnetron sputtering but also for formation of a film of Al, Ti, Cr, SUS, or the like. Furthermore, in the above, the description has been made in terms of the case where film formation via magnetron sputtering is carried out after film formation via plasma polymerization. However, the order of sequence of film formation by plasma polymerization and film formation by magnetron sputtering is not limited as the above description. For example, film formation by plasma polymerization may be executed after film formation by magnetron sputtering. In addition, these film formation processes may be repeated in alternation.

Numerous modifications and alternative embodiments of the invention will be apparent to those skilled in the art in view of the foregoing description. Accordingly, the description is to be construed as illustrative only, and is provided for the purpose of teaching those skilled in the art the best mode of carrying out the invention. The details of the structure and/or function may be varied substantially without departing from the spirit of the invention and all modifications which come within the scope of the appended claims are reserved.

### INDUSTRIAL APPLICABILITY

The film formation system of the present invention is useful as a film formation system which forms a film by making use of a plasma.

In addition, the film formation method of the present invention is useful as a film formation method for forming a film by making use of a plasma.

## Claims

1. A film formation system for generating a plasma within a vacuum chamber and for forming a film on a surface of a substrate by plasma polymerization using said generated plasma, said film formation system comprising:
a high frequency electric power supply which generates a high frequency voltage for said plasma generation;
an exhaust device which evacuates said vacuum chamber;
a plasma source gas supply device which supplies a plasma source gas for said plasma generation to said vacuum chamber;
a control unit which regulates the pressure of said plasma source gas in said vacuum chamber so that said plasma in a reactive-mode is generated;
a material supply device which supplies said vacuum chamber with material for said plasma polymerization;
a cathode and an anode, which are connected to said high frequency electric power supply, for generating an electric discharge to generate said plasma; and
a magnetic field generation device which generates a magnetic field around said cathode.

2. The film formation system according to claim 1, wherein said control unit regulates the flow rate of said plasma source gas which is supplied to said vacuum chamber from said plasma source gas supply device, thereby to regulate the pressure of said plasma source gas.

3. The film formation system according to claim 1, wherein said control unit controls said exhaust device to regulate the degree of vacuum in said vacuum chamber, thereby to regulate the relative pressure of said plasma source gas.

4. The film formation system according to claim 1, wherein
said film formation system further comprises a target for film formation by magnetron sputtering, and said target is disposed in said vacuum chamber; and
at the time of said film formation by magnetron sputtering, said control unit regulates the pressure of said plasma source gas in said vacuum chamber so that said plasma in a metallic-mode is generated.

5. The film formation system according to claim 1, wherein a pair of said cathodes is provided, and said pair of cathodes is connected to said high frequency electric power supply.

6. The film formation system according to claim 5, wherein
said vacuum chamber is composed of an electrically conductive member,
said high frequency voltage is impressed between said pair of said cathodes, and
a chamber connection circuit for selecting cathode, which functions as a positive electrode, from said pair of cathodes, according to change of voltage polarity of said high frequency voltage, and for electrically connecting said selected cathode to said vacuum chamber, is provided.

7. The film formation system according to claim 6, wherein said chamber connection circuit is so configured as to be capable of electrically disconnecting said pair of cathodes from said vacuum chamber.

8. The film formation system according to claim 5, wherein a plurality of sets of said cathode pairs are provided.

9. The film formation system according to claim 1 further comprising a supply roll and a take-up roll, whereby said substrate shaped like a continuous film is continuously supplied to a reaction section of said vacuum chamber in which said cathode is disposed and in which said film formation is carried out.

10. The film formation system according to claim 9, wherein
said reaction section is divided into a first reaction part located upstream relative to a direction in which said substrate is supplied and a second reaction part located downstream relative to said substrate supply direction, and
a cathode connected to a first high frequency electric power supply is disposed in said first reaction part, and
a cathode connected to a second high frequency electric power supply is disposed in said second reaction part, and
the pressure of said plasma source gas in each of said first and second reaction parts is regulated by said control unit independently so that either said plasma in a reactive-mode or said plasma in a metallic-mode is generated in said first reaction part or in said second reaction part independently.

11. The film formation system according to claim 10, wherein said plasma source gas supply device supplies said plasma source gas to said first reaction part and to said second reaction part independently, and
said control unit controls said plasma source gas supply device, thereby to regulate the supply flow rates of said plasma source gas to said first and second reaction parts independently, whereby the pressures of said plasma source gas in said first reaction part and said second reaction part are regulated independently.

12. The film formation system according to claim 10, wherein
said exhaust device evacuates said first reaction part and said second reaction part independently, and
said control unit controls said exhaust device, thereby to regulate the degrees of vacuum of said first and second reaction part independently, whereby the pressures of said plasma source gas in said first and second reaction part are regulated independently.

13. A film formation method in which a plasma is generated within a vacuum chamber and a film is formed on a surface of a substrate by plasma polymerization using said generated plasma, said film formation method comprising the steps of:
placing said substrate in said vacuum chamber;
evacuating said vacuum chamber;
while supplying a plasma source gas for said plasma generation into said vacuum chamber, regulating the pressure of said gas in said vacuum chamber for generation of said plasma in a reactive-mode;
generating said plasma in a reactive-mode from said plasma source gas by application of a high frequency voltage to a cathode and an anode which are disposed in said vacuum chamber;
supplying material for said plasma polymerization into said vacuum chamber; and
while generating a magnetic field around said cathode, performing said film formation by said plasma polymerization using said plasma in a reactive-mode.

14. The film formation method according to claim 13 further comprising the steps of:
disposing a target for film formation by magnetron sputtering in said vacuum chamber,
regulating the pressure of said plasma source gas in said vacuum chamber for generation of said plasma in a metallic-mode,
generating said plasma in a metallic-mode from said plasma source gas by application of a high frequency voltage to said cathode and said anode which are disposed in said vacuum chamber, and
while generating a magnetic field around said cathode, performing said film formation by magnetron sputtering by sputtering said target using said plasma in a metallic-mode.

15. The film formation method according to claim 13, wherein, in said plasma source gas pressure regulating step, said pressure regulation is made by regulating the supply flow rate of said plasma source gas.

16. The film formation method according to claim 13, wherein, in said plasma source gas pressure regulating step, the level of evacuation in said evacuating step is controlled to regulate the degree of vacuum in said vacuum chamber, thereby to regulate the relative pressure of said plasma source gas in said vacuum chamber.

17. The film formation method according to claim 13, wherein a pair of said cathodes is provided which is connected to said high frequency electric power supply.

18. The film formation method according to claim 17, wherein:
said vacuum chamber is composed of an electrically conductive member,
said high frequency voltage is impressed between said pair of said cathodes, and
a chamber connection circuit is provided which selects either cathode of said pair of cathodes, whichever functions as a positive electrode, according to the polarity change of said high frequency voltage, and which electrically connects said selected cathode to said vacuum chamber.

19. The film formation method according to claim 18, wherein said chamber connection circuit is so configured as to be capable of electrically disconnecting said pair of cathodes from said vacuum chamber.

20. The film formation method according to claim 17, wherein a plurality of sets of said cathode pairs are provided.

21. The film formation method according to claim 13 further comprising a substrate supplying step of continuously supplying said substrate shaped like a continuous film to a reaction section of said vacuum chamber in which said cathode is provided and in which said film formation is carried out.

22. The film formation method according to claim 21, wherein:
said reaction section is divided into a first reaction part located upstream relative to a direction in which said substrate is supplied and a second reaction part located downstream relative to said substrate supply direction, and
a cathode connected to a first high frequency electric power supply is disposed in said first reaction part, and
a cathode connected to a second high frequency electric power supply is disposed in said second reaction part, and
in said plasma source gas pressure regulating step, the pressure of said plasma source gas in each of said first and second reaction parts is independently regulated.

23. The film formation method according to claim 22, wherein:
in said plasma source gas pressure regulating step, the supply flow rate of said plasma source gas to said first and second reaction parts are independently regulated for each of said first and second reaction parts, whereby the pressures of said plasma source gas in said first and second reaction parts are independently regulated for each of said first and second reaction parts.

24. The film formation method according to claim 22, wherein:
in said evacuating step, said first and second reaction parts are independently evacuated, and
in said plasma source gas pressure regulating step, the levels of evacuation for each of said first and second reaction parts in said evacuating step are independently controlled to independently regulate the degree of vacuum for each of said first and second reaction parts, whereby the relative pressure of said plasma source gas in said vacuum chamber is regulated.
